(19) Europäisches Patentamt
European Patent Office
Office européen des brevets

(11) **EP 1 860 781 A1**

(12) **EUROPEAN PATENT APPLICATION**
published in accordance with Art. 158(3) EPC

(43) Date of publication:
28.11.2007 Bulletin 2007/48

(51) Int Cl.:
**H04B 1/10** (2006.01)

(21) Application number: 06729064.3

(22) Date of filing: 14.03.2006

(86) International application number:
**PCT/JP2006/305030**

(87) International publication number:
**WO 2006/098325 (21.09.2006 Gazette 2006/38)**

(84) Designated Contracting States:
**DE NL**

(30) Priority: **17.03.2005 JP 2005077531**

(71) Applicant: **Pioneer Corporation**
**Tokyo 153-8654 (JP)**

(72) Inventor: **OHASHI, Toru,**
**Kawagoe Koujou, Pioneer Corporation**
**Kawagoe-shi, Saitama 350-8555 (JP)**

(74) Representative: **Bohnenberger, Johannes**
**Meissner, Bolte & Partner GbR**
**Postfach 86 06 24**
**D-81633 München (DE)**

(54) **NOISE CANCELLER**

(57) It is an object of the present invention to provide a noise canceller which, at a time of removing a noise mixed in an input signal, can remove such a noise without internally generating a noise component.

A noise period detecting unit 8 detects a noise mixing period of a noise in an input signal Sin, while a hold unit 4 holds the input signal Sin and outputs the component of a hold signal SHD during the noise mixing period. An interpolation signal generating unit 6, at an end point of the noise mixing period $\tau$, calculates a difference E between the input signal Sin and the component of the hold signal SHD, generates an interpolation signal Sc which attenuates or rises with a changing amount $\Delta E$ proportional to the difference E serving as an initial value at this time, and outputs the interpolation signal Sc within the interpolation period Tc until the interpolation signal Sc becomes coincident with the input signal Sin. The selector unit 9 outputs an input signal Sin during periods other than a noise mixing period and an interpolation period, outputs the component of the hold signal SHD during the noise mixing period $\tau$, and outputs the interpolation signal Sc during an interpolation period. Then, the signals selected by and outputted from the selector unit 9 are synthesized together, thereby removing the nose, generating and outputting an output signal Sout similar to an input signal Sin, without newly generating a high frequency noise component.

## FIG.2 (A)

**(Cont. next page)**

## FIG.2 (B)

## FIG.2 (C)

## Description

Technical Field

The present invention relates to a noise canceller which removes a noise mixed in an input signal.

Background Technique

In the field of signal processing technique, it is important to remove an external noise mixed in an input signal which is to be processed.

For example, a broadcast receiver or the like mounted in an automobile is apt to be affected by an external noise such as an ignition noise or the like. In view of this, a processing such as a detection and a demodulation or the like is usually not immediately applied to an intermediate frequency signal (IF signal) obtained by mixing together a high frequency reception signal (RF reception signal) and a turning frequency local oscillation signal and by performing a frequency conversion thereon. Rather, a processing such as a detection and a demodulation or the like is usually carried out after an external noise mixed in the intermediate frequency signal has been removed using a noise canceller.

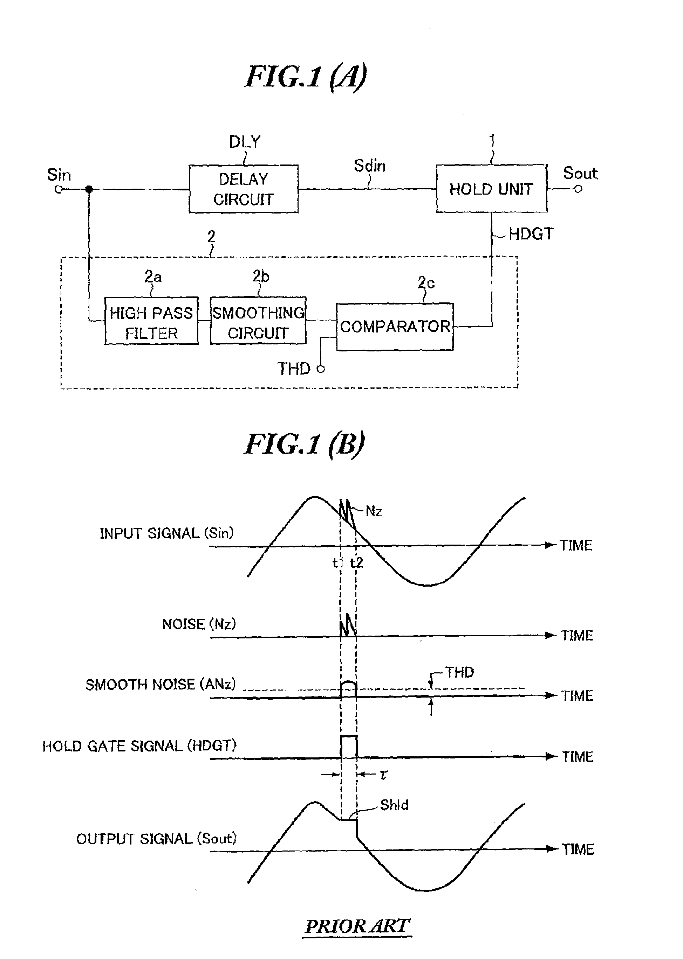

Fig. 1(A) is a block diagram showing the composition of a conventional noise canceller usually provided in a vehicle broadcast receiver, Fig. 1(B) is a timing chart showing the functions of the noise canceller. As shown, the conventional noise canceller comprises a hold unit 1, a hold control unit 2, and a delay circuit DLY.

The hold control unit 2 includes a high pass filter 2a which extracts a noise Nz currently mixed in an intermediate frequency signal (input signal) Sin, a smoothing circuit 2b which smoothes the extracted noise ANz to generate a smooth noise ANz, and a comparator 2c which compares the smooth noise ANz with a predetermined threshold value THD, thereby detecting, as a noise mixing period τ, a period during which the level of the smooth noise ANz is higher than the threshold value THD, thus outputting a hold gate signal HDGT which is logical "H".

The delay circuit DLY has a delay time for correcting a time delay necessary for the hold control unit 2 to generate a hold gate signal HDGT, and supplies an input signal Sdin delayed by the foregoing delay time to the hold unit 1.

When the hold gate signal HDGT is logical "L", the hold unit 1 allows the input signal Sin fed from the delay circuit DLY to pass therethrough without any processing, and outputs the signal as an output signal Sout to a detector or the like. On the other hand, when the hold gate signal HDGT is logical "H", the hold action will be continued, while a hold signal component Shld is outputted as an output signal Sout to the detector or the like. Namely, at a time point t1 at which the hold gate signal HDGT is reversed from logic "L" to "H" (when a noise Nz has been detected), the hold unit 1 will hold the signal component of the input signal Sin. Meanwhile, when the hold gate signal HDGT is becoming logical "H", the hold unit 1 will output a hold signal component Shld having a constant level, and will terminate the hold action at a time point t2 at which the hold gate signal HDGT is again reversed from logic "H" to "L" (when the noise Nz has ended), thereby outputting the input signal Sin as an output signal Sout, thus removing the noise Nz during a noise mixing period τ.

Disclosure of the Invention

Problem(s) to be Solved by the Invention

However, the above-mentioned conventional noise canceller has been found to have the following problem. Namely, at a time point t2 at which the noise mixing period τ has ended, the output signal Sout of the hold unit 1 will be switched over from a hold signal component Shld to an input signal Sin (i.e., Sdin). As a result, the waveform of an output signal Sout will become discrete, undesirably and newly generating a high frequency noise component.

Namely, since a hold signal component Shld kept at a predetermined level during a noise mixing period τ is suddenly switched over to an input signal Sin (i.e., Sdin) at a time point t2 at which the noise mixing period τ has ended (hold is released), even if an external noise is removed, a waveform at a time point t2 of the output signal Sout will become discrete, newly generating a high frequency noise component. For this reason, when a processing such as a detection and a demodulation is carried out based on the output signal Sout, a distortion or the like will occur in a detection signal and a demodulation signal, rendering it difficult to improve a reception quality.

The present invention has been accomplished in view of the above-discussed problems and it is an object of the present invention to provide a noise canceller which does not newly generate a high frequency noise component when applying a hold processing to an input signal. Means for Solving the Problem

An invention recited in claim 1 is a noise canceller for removing a noise mixed in an input signal. The noise canceller comprises: noise period detecting means for detecting a noise mixing period of said noise mixed in said input signal; hold means for holding said input signal and outputting a hold signal component during said noise mixing period; interpolation period setting means for setting an interpolation period following said noise mixing period; interpolation signal generating means which, at a start point of said interpolation period, detects a difference between said hold signal component and said input signal, and during said interpolation period, generates an interpolation signal which attenuates or rises, using said difference as an initial value and in accordance with a changing amount which is proportional to said hold signal component; error detecting means which, during said interpolation period, detects a deviation amount between said interpolation signal and said input signal, and instructs a time point at which said deviation amount becomes 0 as an end point of said interpolation period to said interpolation period setting means; and selector means which outputs, as an output signal, said input signal during periods other than said noise mixing period and said interpolation period, said hold signal component during said noise mixing period, and said interpolation signal during said interpolation period.

Brief Description of the Drawings

Fig. 1 shows the composition and function of a conventional noise canceller.
Fig. 2 provides a block diagram showing the composition of a noise canceller formed according an embodiment of the present invention and graphs showing the functions thereof.
Fig. 3 provides timing charts showing the operations of the noise canceller shown in Fig. 2.
Fig. 4 is a block diagram showing the composition of a noise canceller according to one embodiment.

Best Mode of Carrying Out the Invention

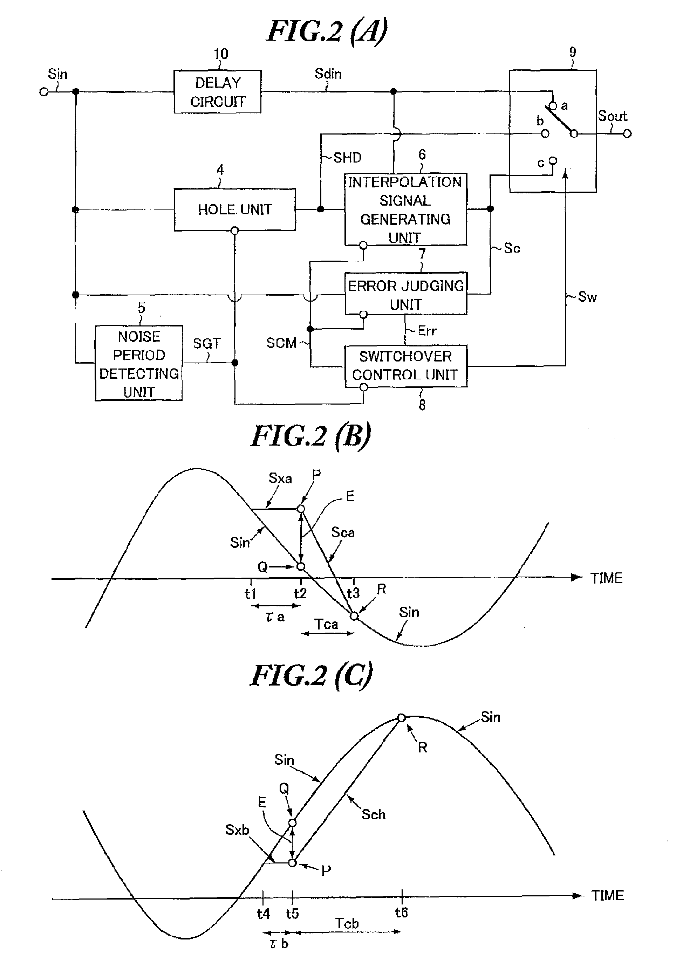

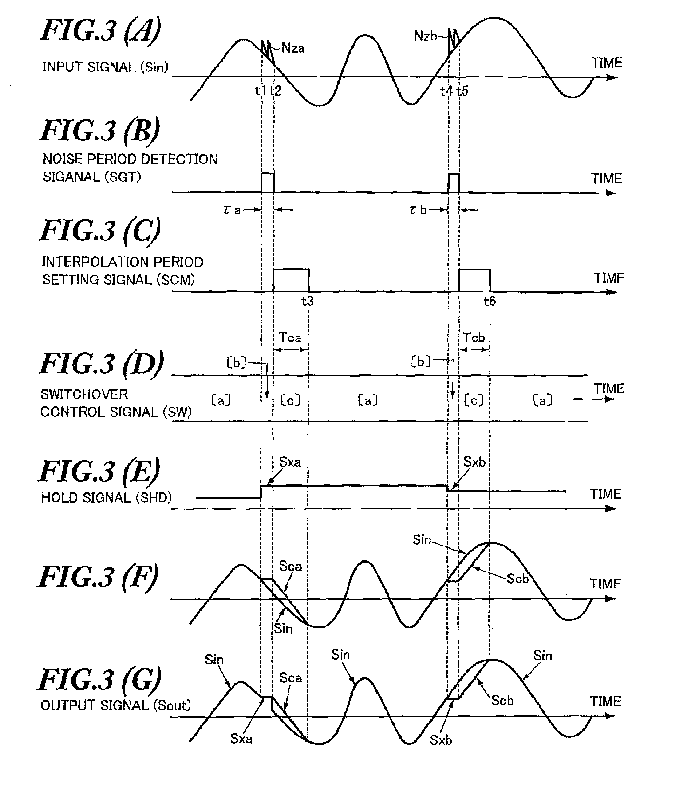

Next, description will be given to explain a preferred embodiment of the present invention with reference to Fig. 2 and Fig. 3. Fig. 2 shows the composition and functions of a noise canceller formed according to an embodiment of the present invention. Fig. 3 provides timing charts showing the operations of the noise canceller.

As shown in Fig. 2, the noise canceller 3 comprises a hold unit 4, a noise period detecting unit 5, an interpolation signal generating unit 6, an error judging unit 7, a switchover control unit 8, and a selector unit 9, thereby rendering it possible to remove a noise from an input signal Sin and outputting an output signal Sout. Further, the present embodiment is provided with a delay circuit 10 for performing a timing adjustment.

The noise period detecting unit 5 detects a noise currently mixed in an input signal Sin, and outputs a noise period detection signal SGT indicating a period τ during which a noise is occurring (hereinafter, referred to as "noise mixing period").

The hold unit 4 holds an input signal Sin at a start point of a noise mixing period τ in accordance with a noise period detection signal SGT. Namely, at a start point of a noise mixing period τ indicated by a noise period detection signal SGT, the hold unit 4 receives the signal component of an input signal Sin immediately before the noise is mixed. Then, another noise is detected after a predetermined time has passed and a next noise period detection signal SGT is supplied, thereby continuing to output a hold signal SHD held at the level of the above-held signal component Sx (hereinafter, referred to as "held signal component") during a period lasting until a start point of a next noise mixing period τ.

The delay circuit 10 delays an input signal Sin by a predetermined time, and outputs the delayed signal as an input signal Sdin. Namely, the delay circuit 10 is provided for adjusting a timing of an internal processing time of the noise canceller 3. Here, although the delay circuit 10 exhibits a timing adjustment function, the noise canceller 3 of the present embodiment as a whole can also be formed to effect such a timing adjustment.

The switchover control unit 8 includes interpolation period setting means for setting an interpolation period Tc, and control means for switching over the selector unit 9.

Namely, the switchover control unit 8 generates an interpolation period setting signal SCN for setting an interpolation period Tc following a noise mixing period τ, in synchronism with an output of a noise period detection signal SGT fed from the noise period detecting unit 5, and supplies the interpolation period setting signal SCN to the interpolation signal generating unit 6 as well as to the error judging unit 7.

Here, after the switchover control unit 8 has begun to output an interpolation period setting signal SCM subsequent to a noise mixing period τ, it will continuously output an interpolation period setting signal SCM during a period lasting until the level of an error signal Err supplied from the error judging unit 7 becomes substantially "0". Accordingly, an interpolation period Tc set by the interpolation period setting signal SCM is a so-called length-variable period which changes with a timing change of a time point at which the level of the error signal Err becomes substantially "0".

Furthermore, the switchover control unit 8 generates and outputs a switchover control signal SW for controlling the switchover of the selector unit 9. Namely, during periods other than the noise mixing period τ indicated by the noise period detection signal SGT as well as the interpolation period Tc, the selector unit 9 is connected to the switchover contact point a by virtue of a switchover control signal SW, thereby outputting the input signal Sdin as an output signal Sout. Further, within the noise mixing period τ, the selector unit 9 is connected to the switchover contact point b by virtue of a switchover control signal SW, thereby outputting as an output signal Sout the hold signal component Sx of the hold signal SHD outputted from the hold unit 4. Moreover, within the interpolation period Tc, the selector unit 9 is connected to the switchover contact point c by virtue of a switchover control signal SW, thereby outputting as an output signal Sout a below-mentioned interpolation signal Sc generated in the interpolation signal generating unit 6.

Therefore, once the selector unit 9 performs a switchover operation under the control of a switchover control signal SW, an input signal Sdin not containing any noise (i.e., Sin) and the hold signal component Sx as well as an interpolation signal Sc are synthesized together with the passing of time, thereby outputting a synthesized signal as an output signal Sout.

The interpolation signal generating unit 6 generates an interpolation signal Sc within an interpolation period Tc, and supplies the signal to a switchover contact point c of the selector unit 9 as well as to the error judging unit 7. Here, the interpolation signal Sc is generated as follows. At first, once a start point (in other words, an end point of a noise mixing period τ) of an interpolation period Tc is specified by an interpolation signal SCM, the interpolation signal generating unit 6 will calculate a difference E between the level (amplitude) P of the hold signal component Sx of the hold signal SHD and the level (amplitude) Q of an input signal Sin.

Further, by calculating the difference E in accordance with a divider N for dividing into a plurality of portions a period equivalent to an inverse of a maximum frequency of an input signal Sin which changes within a predetermined frequency range, a changing amount ΔE per time unit is calculated. Namely, the divider N is determined in accordance with the maximum frequency of the input signal Sin which is to be processed, and stored in the interpolation signal generating unit 6. If fmax represents the maximum frequency of the input signal Sin and 1/fmax represents the period of its inverse, the divider N will be decided to be a number capable of finely N-dividing the period 1/fmax. In this way, it is possible to apply an interpolation processing to the input signal Sin, taking as unit time each time 1/(N×fmax) obtained by N-dividing the period 1/fmax, while at the same time continuously and maximally reducing an information lacking of the input signal Sin. In the following, description will be given to explain in more detail the interpolation processing.

Moreover, when a difference E of a time at which a changing amount ΔE has been found is a positive value, the level P of the hold signal component Sx will be taken as an initial value, and an interpolation signal Sc will be generated and outputted, the level of which attenuates a changing amount ΔE each time a unit time has passed (more strictly, the level attenuates an absolute value |ΔE| each time).

On the other hand, when the foregoing difference E is a negative value, the level P of the hold signal component Sx will be taken as an initial value, and an interpolation signal Sc will be generated and outputted, the level of which increases a changing amount ΔE each time a unit time has passed (more strictly, the level increases an absolute value |ΔE| each time).

If a principle for generating an interpolation signal Sc described above is explained using several equations, it can be expressed as follows.

At a start point of an interpolation period Tc, as shown in the following equations (1) and (2), a difference E between the level P of the hold signal component Sx and the level Q of an input signal Sdin (i.e., Sin) is calculated, followed by calculating a changing amount ΔE. Such a changing amount ΔE is a positive value or a negative value.

[Equation 1]

$$E = P - Q \quad \dots (1)$$

$$\Delta E = E/N \quad \dots (2)$$

Then, as shown in the following equation (3), a correction signal Sc is generated and outputted with the passing of a time t proportional to a unit time, with the level P of the hold signal component Sx serving as an initial value. When the foregoing levels P and Q are in a relation of P>Q, the difference E and the changing amount ΔE will become positive values, and the level of the correction signal Sc will gradually attenuate. On the other hand, if the foregoing levels P and Q are in a relation of P<Q, the difference E and the changing amount ΔE will become negative values, and the level of the correction signal Sc will gradually increase. Further, if P=Q, the correction signal Sc will have the same value as the input signal Sdin (i.e., Sin).

[Equation 2]

$$Sc = P - \Delta Ext \quad \dots (3)$$

Next, once the error judging unit 7 receives an instruction indicating a start point (i.e., an end point of a noise mixing period τ) of an interpolation period Tc by virtue of an interpolation period setting signal SCN fed from the switchover control unit 8, it will successively calculate a level differences Err (deviations) between the input signal Sdin (i.e., Sin) and the interpolation signal Sc, and supply the same to the switchover control unit 8. Namely, the error judging unit 7 detects, as a level error Err, a deviation amount between an interpolation signal Sc outputted from the interpolation signal generating unit 6 and indicated in the above equation (3) on one hand and an input signal Sin on the other. In this way, when the level of an interpolation signal Sc attenuates or increases gradually and an error Err with respect to the level of the input signal Sin becomes substantially "0", i.e., smaller than a technically detectable minimum resolution (for example, |ΔE|), the level of the interpolation signal Sc will become coincident with the level of the input signal Sdin (i.e., Sin), thereby informing the switchover control unit 8 of a time point at which the foregoing coincidence has been reached by virtue of the error signal Err.

Then, once the switchover control unit 8 judges a time point at which the error Err has become substantially "0", the interpolation period Tc will be terminated as described above, so will the output of the interpolation period setting signal SCM. Further, within the interpolation period Tc, the selector unit 9 connected to the contact point c is switched over to the contact point a by virtue of the switchover control signal SW, thereby switching an interpolation signal Sc outputted as an output signal Sout over to an input signal Sdin.

Next, description will be given to explain an operation of the noise canceller 3 of the present embodiment having the above-discussed composition, with reference to Fig. 2(B), 2(C) and Fig. 3. However, since the noise canceller 3 of the present embodiment as a whole has an adjusted timing, the respective elements 4 to 10 are supposed to involve no delay time necessary for processing, thereby ensuring an easy description of the present invention. Namely, although the input signals Sin and Sdin are deviated from each other, since they can all be used as information, description of the present invention will proceed without distinguishing them from each other. Moreover, the following description will be given to explain an example of removing external noises Nza and Nzb such as ignition noises mixed in two positions of the input signal Sin, as shown in Fig. 3(A).

Here, a noise Nza indicates that it was mixed within a time period lasting from a time point t1 to a time point t2 during which the level of the input signal Sin decreases gradually, while a noise Nzb indicates that it was mixed within a time period lasting from a time point t4 to a time point t5 during which the level of the input signal Sin increases gradually.

With respect to such an input signal Sin, the noise period detecting unit 5 detects noises Nza and Nzb in the order of a time passing, thereby outputting a noise period detection signal SGT indicating respective mixing periods τa and τb, as shown in Fig. 3(B).

At first, when a noise period detection signal SGT indicating a noise mixing period τa has been outputted, the hold unit 4 will hold a signal component at a time point t1 of the input signal Sin as a hold signal component Sx (expressed as Sxa in the graph), thereby outputting a hold signal SHD not containing a noise Nza.

Furthermore, as shown in Fig. 3(D), the switchover control unit 8 controls the switchover of the selector unit 9 at a time point t1, so that the selector unit 9 connected to the contact point a will be switched over to the contact point b before the noise Nza is detected. Then, within the noise mixing period τa, the selector unit 9 is switched over to the contact point b. In this way, as shown in Fig. 3(G), an output signal Sout will have the same waveform as the input signal Sin (i.e., Sdin) before the time point t1, and have the same signal level as the hold signal component Sxa of the hold signal SHD within the noise mixing period τa, thereby forming a signal not containing a noise Nza.

Next, as shown in Fig. 3(C), at an end point t2 of the noise mixing period τa, the switchover control unit 8 begins to output the interpolation period setting signal SCM, and switches the selector unit 9 over to the contact point c by virtue of the switchover control signal SW. Further, as schematically shown in Fig. 3(F), at the end point t2 of the noise mixing period τa, when the switchover control unit 8 begins to output the interpolation period setting signal SCM, the interpolation signal generating unit 6 will begin to generate and output an interpolation signal Sc (expressed as Sca in the graph), while the error judging unit 7 will detect, one by one with the passing of a time t, a deviation between the interpolation signal Sca and the input signal Sin (i.e., Sdin).

Next, description will be given to explain a principle of generating the interpolation signal Sc (i.e., Sca).

As described above, when the hold signal component Sxa is outputted as an output signal Sout within a noise mixing period τa and an interpolation period setting signal SCM is outputted from the control unit 8 at the time point t2, once a noise mixing period τa shifts to an interpolation period Tc (expressed as Tca in the graph), the interpolation signal generating unit 6 will perform a series of processing represented by the foregoing equations (1) and (2), thereby detecting a level difference E between the level P of the hold signal component Sxa and the level Q of the input signal Sin (i.e., Sdin) at the time point t2, followed by calculating a changing amount ΔE. Then, the interpolation signal generating unit 6 repeats the processing represented by the above equation (3) until the interpolation period Tca expires, thereby generating and outputting an interpolation signal Sca whose level gradually attenuates and becomes close to the level of the input signal Sin with the passing of a time t. Moreover, within the interpolation period Tca, since the selector unit 9 is connected to the contact point c, the interpolation signal Sca is outputted as an output signal Sout, as shown in Fig. 3 (G). Then, at a time point t3 expressed by a sign R in Fig. 2(B), once an error Err between an interpolation signal Sca and an input signal Sin (i.e., Sdin) becomes substantially "0" as detected by the error judging unit 7, the switchover control unit 8 will terminate the output of the interpolation period setting signal SCM. Meanwhile, the selector unit 9 is switched over to the contact point a by virtue of the switchover control signal SW, thereby outputting the input signal Sdin as an output signal Sout.

In this way, when, at a time point t2 of the noise mixing period τa, the hold signal component Sxa is larger than the level of the input signal Sin, an interpolation signal Sca whose level attenuates gradually will be generated. As a result, it is possible to set at the interpolation period Tca a period which lasts until the interpolation signal Sca and the input signal Sin become substantially coincident with each other, and to automatically and variably adjust the interpolation period Tca in response to a level difference E between the hold signal component Sxa and the input signal Sin at the foregoing time point t2.

In the prior art, a noise component is internally generated if a hold signal component is suddenly switched over to an input signal at a time a noise mixing period expires. In the present embodiment, since the hold signal component Sxa whose level gradually attenuates is outputted subsequent to the hold signal component Sxa, it is possible to exhibit an advantage of not generating a high frequency noise component.

Next, description will be given to explain an operation of the noise canceller when a noise Nzb has been detected during a period which lasts from a time point t4 to a time point t5, as shown in Fig. 3.

When the noise period detection signal SGT indicating a noise mixing period τb has been outputted, as shown in Fig. 3(E), the hold unit 4 will hold the signal component of the input signal Sin at a time point t4 as a hold signal component Sx (expressed as Sxb in the graph), and output the same as a hold signal SHD not containing the noise Nzb.

Furthermore, as shown in Fig. 3(D), at the time point t4 the switchover control unit 8 controls the switchover of the selector unit 9, and allows the selector unit 9 connected with the contact point a to be connected to the contact point b before a noise Nzb is detected. Then, within a noise mixing period τb, the selector unit 9 is continued to be connected to the contact point b. In this way, as shown in Fig. 3(G), the output signal Sout will have the same waveform as the input signal Sin (i.e., Sdin), and have the same level as the hold signal component Sxb of the hold signal SHD within the noise mixing period τb, thereby forming a signal not containing a noise Nzb.

Then, as shown in Fig. 3(C), the switchover control unit 8, at an end point t5 of the noise mixing period τb, starts the output of the interpolation period setting signal SCM and connects the selector unit 9 to the contact point c by virtue of the switchover control signal SW. Further, as schematically shown in Fig. 3(F), at an end point t5 of the noise mixing period τb, the switchover control unit 8 starts the output of the interpolation period setting signal SCM. With the foregoing process, the interpolation signal generating unit 6 starts the generation and the output of the interpolation signal Sc (expressed as Scb in the graph), and the error judging unit 7 gradually detects, with the passing of the time t, a deviation amount between the interpolation signal Scb and the input signal Sin (i.e., Sdin).

Next, description will be given to a principle of generating the interpolation signal Sc (i.e., Scb), with reference to Fig. 2(C) which is an enlarged graph.

As described above, during the noise mixing period τb, the hold signal component Sxb is outputted as an output signal Sout, while at a time point t5 an interpolation period setting signal SCM is outputted from the switchover control unit 8. With the foregoing process, once the process shifts from the noise mixing period τb to the interpolation period Tc (expressed as Tcb in the graph), the interpolation signal generating unit 6 performs a series of processing expressed in the foregoing equations (1) and (2), detects a level difference E between the level P of the hold signal component Sxb and the level Q of the input signal Sin at the time point t5, and further calculates a changing amount ΔE. Then, the interpolation signal generating unit 6 repeats the processing represented by the foregoing equation (3) until the interpolation period Tcb expires, thereby outputting an interpolation signal Scb whose level gradually rises with the passing of the time t and approaches the level of the input signal Sin (i.e., Sdin). Further, within the interpolation period Tcb, since the selector unit 9 is connected to the contact point c, the interpolation signal Scb is outputted as an output signal Sout, as shown in Fig. 3(G). Then, at a time point t6 represented by a sign R in Fig. 2(C), once an error Err detected by the error judging unit 7 and representing a difference between the interpolation signal Scb and the input signal Sin becomes substantially "0", the switchover control unit 8 will terminate the output of the interpolation period setting signal SCM, and at the same time connect the selector unit 9 to the contact point a by virtue of the switchover control signal SW, thereby outputting the input signal Sdin as an output signal Sout.

In this way, when, at the time point t5 of the noise mixing period τb, a hold signal component Sxb is smaller than the level of an input signal Sin, since an interpolation signal Scb whose level rises gradually is generated, it is possible to set, at the interpolation period Tcb, a period which lasts until the interpolation signal Scb and the input signal Sin become substantially coincident with each other. Further, it is possible to automatically and variably adjust the interpolation period Tcb in response to a level difference E between the hold signal component Sxb and the input signal Sin at the foregoing time point t5.

In the prior art, a noise component is internally generated if a hold signal component is suddenly switched over to an input signal at a time a noise mixing period expires. In the present embodiment, since the hold signal component Sxa whose level gradually rises is outputted following the hold signal component Sxb, it is possible to exhibit an advantage of not generating a high frequency noise component.

In this way, using the noise canceller 3 of the present embodiment makes it possible to obtain the following advantage. Namely, as shown in Fig. 3 (G), when the noise mixing period τ expires, since it is possible to perform an interpolation using an interpolation signal Sc whose level changes gradually, to effect a switchover to the input signal Sin (i.e., Sdin) without having to carry out a sudden switchover from the hold signal component to the input signal Sin, it becomes possible to prevent the occurrence of a high frequency noise component.

Furthermore, in the present embodiment, since the changing amount ΔE of the interpolation signal Sc is determined in response to a difference E between the level P of the hold signal component Sx and the level Q of the input signal Sin, it is possible to automatically and variably adjust the interpolation period Tc in response to a change in the amplitude of an actual input signal Sin, thus rendering it possible to perform an interpolation of an appropriate amount, without causing a distortion or the like in the waveform of the output signal Sout.

Further, since a divider N at a time of computing a changing amount ΔE is set at a number capable of finely dividing the period of an inverse 1/fmax of a maximum frequency fmax of the input signal Sin, an interpolation period Tc for performing an interpolation will not become a long time lasting from the noise mixing period τ and exceeding 1 cycle of the input signal Sin. In this way, it is possible to perform an interpolation following an amplitude change of an input signal Sin, thereby enabling an appropriate amount of interpolation, without causing a distortion or the like in the waveform of the output signal Sout.

The noise canceller 3 of the present embodiment described above, as shown in the foregoing equation (3), gradually decreases or increases the level of an interpolation signal Sc, using a method of subtracting, from the level P of the hold signal component Sx, a value obtained by multiplying a changing amount ΔE with an elapsed time $\underline{t}$. However, it is also possible to perform a repeated processing for decreasing or increasing the changing amount ΔE, with respect to a new value obtained by decreasing or increasing the changing amount ΔE from the level P of the hold signal component Sx, thereby allowing the level of the interpolation signal Sc to gradually attenuate or rise.

Moreover, in order to gradually attenuate and increase the level of the interpolation signal Sc according to a changing amount ΔE, it is possible to employ a shift register which realizes a multiplication and a division by virtue of an amplifier, a variable attenuator, a multiplier, and a bit shift.

Moreover, as described above with reference to Figs. 2 (B) and 2(C), detection is performed to detect a difference E between the level P of a hold signal component Sx and an input signal Sin at end points t2 and t5 of a noise mixing period, thereby generating an interpolation signal Sc with the foregoing difference E serving as an initial value. On the other hand, it is also possible for the level P of the hold signal component Sx to be detected at a start point of the noise mixing period.

Further, the hold unit 4 may be a circuit which, at least at a noise mixing period τ specified by a noise period detection signal SGT, maintains the hold signal component Sx.

Moreover, the noise canceller 3 of the present embodiment described above, has such a universality that it can be generally used in an electronic device. For, example, such a noise canceller can be used to remove an external noise mixed in an intermediate frequency signal reproduced in a front endunit of a broadcast receiver, a detected baseband signal, or a demodulation signal modulated in a demodulator.

In addition, the noise canceller 3 of the present embodiment described above can be formed of an analogue circuit, or a digital circuit capable of performing a noise canceling by virtue of digital signal processing.

Besides, the noise canceller 3 of the present invention can be formed of either a so-called hardware such as an analog circuit or a digital circuit, or a so-called program which performs a computation processing or the like by virtue of means such as a microprocessor (MPU) or a digital signal processor (DSP).

Example

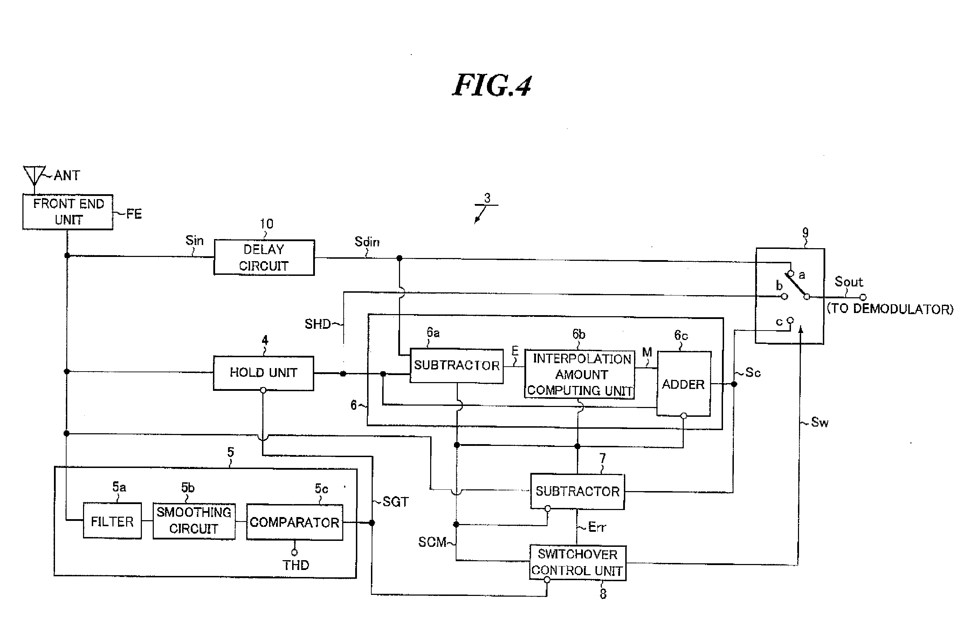

Next, description will be given to explain an example of a noise canceller provided in an automobile FM receiver for receiving an FM broadcast, with reference to Fig. 4. Fig. 4 is a block diagram showing the composition of the noise canceller of the this example, using the same reference numerals to represent the elements which are the same as or corresponding to those in Fig. 2(A).

As shown in Fig. 4, the noise canceller 3 of this example is so connected that it can receive as an input signal Sin a baseband signal detected in the front end unit FE provided in an FM receiver, remove an external noise such as an ignition noise, and output the baseband signal Sout to a demodulator.

Namely, the front end unit FE of the FM receiver mixes a high frequency reception signal (RF reception signal) produced in a reception antenna ANT with a local oscillation signal having a tuning frequency so as to perform a frequency conversion, thereby generating an intermediate frequency signal (IF signal), followed by limiting the band of the intermediate frequency signal and amplifying the signal to a level capable of receiving a signal processing, thus generating a baseband signal as a desired signal component. Then, the baseband signal is supplied as an input signal Sin to the noise detecting unit 5, as well as to the correction signal generating unit 6 and the contact point $\underline{a}$ of the selector unit 9 through the delay circuit 10.

The delay circuit 10 delays the input signal Sin for a predetermined time and outputs the delayed signal as an input signal Sdin. Namely, the delay circuit 10 is provided to perform a timing adjustment on the internal processing time of the noise canceller 3. Besides, although the delay circuit 10 is shown as an example for performing a timing adjustment, the noise canceller 3 of the present invention as a whole can effect such a timing adjustment.

The noise detecting unit 5 comprises a high pass filter 5a, a smoothing circuit 5b, and a comparator 5c. The filter 5a passes an external noise mixed in the input signal Sin, the smoothing circuit 5b smoothes the noise so as to generate a smooth noise component, while the comparator 5a having a hysteresis performs a comparison between the level of the smooth noise component and a predetermined threshold value THD, thereby detecting as a noise mixing period τ a period during which the level of the smooth noise component becomes higher than the threshold value THD, thus outputting a noise period detection signal SGT.

The interpolation signal generation unit 6 comprises a subtractor 6a, an interpolation amount computing unit 6b formed of an integrator, and an adder 6c.

The subtractor 6a operates in synchronism with a start point of a correction period (i.e., an end point of a noise mixing period $\tau$) specified by an interpolation period setting signal SCN supplied from the switchover control unit 8, calculates a difference E between the hold signal component Sx of the hold signal SHD supplied from the hold unit 4 and an input signal Sdin fed from the delay circuit 10, and supplies the same to the interpolation amount computing unit 6b.

The interpolation amount computing unit 6b calculates a changing amount $\Delta E$ from a ratio (E/N) of the difference E to a predetermined divider N, integrates the changing amount $\Delta E$ according to the passing of a time $\underline{t}$, and supplies an integration value M to the adder 6c. At a start point of a correction period specified by an interpolation period setting signal SCM, the adder 6c receives and holds the hold signal component Sx of the hold signal SHD supplied from the hold unit, adds together the hold signal component Sx and the integration value M according to the passing of the time $\underline{t}$, thereby generating a correction signal Sc and supplying the same to the switchover contact point c of the selector unit 9.

The error judging unit 7 shown in Fig. 2 (A) is formed of the subtractor 7 shown in Fig. 4, and calculates and outputs an error Err equivalent to a deviation amount between an interpolation period Tc and an input signal Sin within an interpolation period Tc set by an interpolation period setting signal SCM.

The selector unit 9 is formed of 3-input and 1-output type analog switch.

The switchover control unit 8 is formed of a system controller such as a microprocessor (MPU) provided in an FM receiver.

Then, the noise canceller 3 of the present embodiment described above, performs the same operation as the noise canceller 3 shown in Fig. 2(A), so as to remove an external noise mixed in an input signal Sin which is a baseband signal, thereby outputting an output signal Sout which is the baseband signal and supplying the same to the demodulator.

According to the noise canceller 3 of this example, similar to the above-described embodiment, it becomes possible to remove an external noise, reduce essential elements, so as to realize a simplified noise canceller, without causing waveform distortion or the like in an output signal Sout, nor causing a high frequency noise component. In particular, since it is possible to form a simplified structure, the noise canceller of the present invention is suitable for use in an automobile receiver, a portable receiver or the like, thereby providing an excellent advantage.

## Claims

**1.** A noise canceller for removing a noise mixed in an input signal, said noise canceller comprising:

noise period detecting means for detecting a noise mixing period of said noise mixed in said input signal;

hold means for holding said input signal and outputting a hold signal component during said noise mixing period;

interpolation period setting means for setting an interpolation period following said noise mixing period;

interpolation signal generating means which, at a start point of said interpolation period, detects a difference between said hold signal component and said input signal, and during said interpolation period, generates an interpolation signal which attenuates or rises, using said difference as an initial value and in accordance with a changing amount which is proportional to said hold signal component;

error detecting means which, during said interpolation period, detects a deviation amount between said interpolation signal and said input signal, and instructs a time point at which said deviation amount becomes 0 as an end point of said interpolation period to said interpolation period setting means; and

selector means which outputs, as an output signal, said input signal during periods other than said noise mixing period and said interpolation period, said hold signal component during said noise mixing period, and said interpolation signal during said interpolation period.

**2.** The noise canceller according to claim 1, wherein said changing amount is a value equivalent to a ratio of a number to said difference, said number being set for dividing into several portions a period corresponding to a maximum frequency of said input signal.

**3.** A noise removing method for use with a noise canceller for removing a noise mixed in an input signal, said method comprising:

a noise period detecting step for detecting a noise mixing period of said noise mixed in said input signal;

a hold step for holding said input signal and outputting a hold signal component during said noise mixing period;

an interpolation period setting step for setting an interpolation period following said noise mixing period;

an interpolation signal generating step which, at a start point of said interpolation period, detects a difference between said hold signal component and said input signal, and during said interpolation period, generates an interpolation signal which attenuates or rises, using said difference as an initial value and in accordance with a changing amount which is proportional to said hold signal component;

an error detecting step which, during said interpolation period, detects a deviation amount between said interpolation signal and said input signal, and instructs a time point at which said deviation amount becomes 0 as an end point of said interpolation period to said interpolation period setting step; and

a selecting step which outputs, as an output signal, said input signal during periods other than said noise mixing period and said interpolation period, said hold signal component during said noise mixing period, and said interpolation signal during said interpolation period.

## *FIG.1 (A)*

## *FIG.1 (B)*

*PRIOR ART*

## *FIG.2 (A)*

## *FIG.2 (B)*

## *FIG.2 (C)*

## FIG.3 (A)

INPUT SIGNAL (Sin)

Nza

Nzb

TIME

t1 t2　　　　t4 t5

## FIG.3 (B)

NOISE PERIOD DETECTION
SIGANAL (SGT)

TIME

τ a →|　|←　　τ b →|　|←

## FIG.3 (C)

INTERPOLATION PERIOD
SETTING SIGNAL (SCM)

TIME

t3　　　　　t6

## FIG.3 (D)

SWITCHOVER
CONTROL SIGNAL (SW)

Tca　　　　Tcb

[b]→|　　　　[b]→|

[a]　|↓| [c]　[a]　　|↓| [c]　　[a]

TIME

## FIG.3 (E)

HOLD SIGNAL (SHD)

Sxa　　　　Sxb

TIME

## FIG.3 (F)

Sin

Sca

Scb

Sin

TIME

Sin

## FIG.3 (G)

OUTPUT SIGNAL (Sout)

Sin　　　Sin　　　　Sin

Sca　　　　　Scb

Sxa　　　　Sxb

TIME

**FIG.4**

## INTERNATIONAL SEARCH REPORT

| | International application No. |
|---|---|
| | PCT/JP2006/305030 |

**A. CLASSIFICATION OF SUBJECT MATTER**
*H04B1/10*(2006.01)

According to International Patent Classification (IPC) or to both national classification and IPC

**B. FIELDS SEARCHED**

Minimum documentation searched (classification system followed by classification symbols)
H04B1/10

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2004-056173 A (Mitsubishi Electric Corp.), 19 February, 2004 (19.02.04), Full text; Figs. 1 to 15 (Family: none) | 1-3 |
| A | JP 2004-187074 A (Pioneer Electronic Corp.), 02 July, 2004 (02.07.04), Full text; Figs. 1 to 7 & EP 1427111 A2 & US 2004/0108906 A1 | 1-3 |
| A | JP 2003-069435 A (Pioneer Electronic Corp.), 07 March, 2003 (07.03.03), Full text; Figs. 1 to 7 & EP 1286472 A2 & US 2003/0039327 A1 | 1-3 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 27 April, 2006 (27.04.06) | 16 May, 2006 (16.05.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

## INTERNATIONAL SEARCH REPORT

International application No.

PCT/JP2006/305030

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2003-069389 A  (Pioneer Electronic Corp.),<br>07 March, 2003 (07.03.03),<br>Full text; Figs. 1 to 7<br>& EP 1286472 A2          & US 2003/0039327 A1 | 1-3 |
| A | JP 57-176511 A  (Hitachi, Ltd.),<br>29 October, 1982 (29.10.82),<br>Full text; Figs. 1 to 7<br>& EP 0044687 A1          & US 4843488 A | 1-3 |
| A | JP 61-030183 A  (Sanyo Electric Co., Ltd.),<br>12 February, 1986 (12.02.86),<br>Full text; Figs. 1 to 6<br>(Family: none) | 1-3 |

Form PCT/ISA/210 (continuation of second sheet) (April 2005)